# EUROPEAN PATENT APPLICATION

(11) **EP 3 284 845 A1**
(43) Date of publication of application: **21.02.2018**
(21) Application number: 16779952.7
(22) Date of filing: 05.04.2016
(51) Int. Cl.: C23C 16/04, B23B 27/14, B23B 27/20, C23C 14/04, C23C 14/06, C23C 16/27

(54) **PROTECTIVE FILM AND METHOD FOR PRODUCING SAME**

(30) Priority: 16.04.2015 JP 2015084478
(71) Applicant: iMott Inc., Yokohama-shi Kanagawa 2250012 (JP)
(72) Inventor: MATSUO, Makoto, Yokohama-shi Kanagawa 225-0012 (JP); HAYASHIDA, Tatsuaki, Yokohama-shi Kanagawa 224-0014 (JP); IIDA, Akiyoshi, Tokyo 142-0064 (JP)
(74) Representative: Keirstead, Tanis Evelyne
(86) International application number: PCT/JP2016/061168
(87) International publication number: WO 2016/167161

(57) **Abstract**

The purpose of the present invention is to obtain a protective film having a segmented structure that is stable in terms of strength and that prevents the destruction or damage of a groove structure due to load deformation stress from outside and inside forces, by means of, in particular, a structure that connects a side surface of a groove to the bottom section of the groove and a structure of the bottom section of the groove. The present invention is a protective film having a segmented structure, the film being formed by depositing a film on a base material, wherein the protective film is obtained by depositing the protective film, after machining a groove in the base material, forming spaces between the segmented protective film on the base material, and the vertical cross-sectional surface of a part where the groove side surface and the groove bottom surface intersect is connected by a downward convex curve and the vertical cross-sectional surface of the bottom section of the groove is a downward convex curve or a straight line.

## Description

### TECHNICAL FIELD

The present invention relates to a protective film, in particular a diamond-like carbon (DLC) protective film, having a segmented structure, obtained by depositing a film on a base material, and to a method for producing the protective film. The protective film may be continuous on a base material or may be discontinuous divided by grooves.

### BACKGROUND ART

In recent years, a technology for coating a hard film, on a material surface, that has long life and high reliability and can be used in a carefree manner has been sought, as a protective film for mechanical components or the like. In the field of coating a hard film, a hard carbon film, particularly diamond-like carbon (DLC), has been highly evaluated as a material that enhances the slidability of a component by forming a film on a component surface. DLC is a material that contains carbon as a main component, is generally amorphous while carbon atoms have graphite sp² bonds and diamond sp³ bonds, and exhibits intermediate physical properties between graphite and diamond. In addition, it is known to have low coefficient of friction and high wear resistance due to its film characteristics and surface smoothness and has been widely utilized as a surface coating that enhances slidability on the sliding planes of various machines, tools, internal combustion engines and the like.

However, when external force is applied to a base material on which a hard film such as DLC is deposited in order to improve wear resistance, the base material is deformed to apply large distortion to the hard film and to sometimes peel off the hard film from the base material. In order to solve this, there was suggested a protective film having a segmented structure, wherein a film formed divided into segments is deposited on a base material (Patent Literature 1).

It is known that, so as to obtain such a protective film having a segmented structure, a base material is masked using a wire gauze of a tungsten wire or the like and a protective film is thereafter deposited (Patent Literature 1). More specifically, the parts corresponding to wire gauze meshes constitute segments by performing masking using a wire gauze of a tungsten wire or the like, a lattice-shaped segmented film is obtained, and wire gauze parts, namely, the parts corresponding to the net wires of the wire gauze constitute the spacings between adjacent segments.

A segmented shape by masking using a wire gauze is limited by the processability (degree of ease of deformation of a wire gauze) of the wire gauze. For example, since the net wires of an ordinary wire gauze have a uniform diameter, a film deposited on a base metal on which the wire gauze as masking is set may only have a constant thickness. In addition, since the meshes of an ordinary wire gauze are uniform, the shapes of segments are difficult to change correspondingly to the portion on which a film is formed. In addition, even masking by a wire gauze can be relatively easily applied when a base material to be masked is planar while the application of the masking by the wire gauze is difficult when the base material has a three-dimensional shape. For example, for covering a three-dimensional body, it is necessary to finely divide a planar wire gauze correspondingly to the planes constituting the three-dimensional body and connect the divided portions, which requires a lot of time and effort, maintenance of the uniformity of segmented shapes at every batch of the film deposition work becomes difficult, and the quality control of a protective film is further precluded.

The present inventors provided a protective film and a method for producing the same without masking using a wire gauze, in which a base material is masked using a drawing material, or is grooved using a cutting tool, and then a protective film is deposited on the base material (Patent Literature 2). In accordance with the invention of Patent Literature 2, a protective film having a segmented structure is easily formed and a segmented structure can be attained on the more complicate surface of a base material, comparing to using a wire gauze as a masking. However, the drawing speed of commonly available printing devices is about 20mm/sec and the cutting speed of micro-routers is about 0.1mm/sec, and hence an improved manufacturing technique, which can be performed at a higher speed and with a higher degree of adapterbility, has been required. Only a groove depth corresponding to a film thickness, or equivalently, a groove depth of several nanometers to several hundred micrometers can be obtained in the protective film having a segmented structure made by being masked with the drawing material while a groove with a depth of around 1 mm can easily be obtained by using this method of groove-processing a base material using a cutting tool. However, a cutting tool cannot easily be introduced for the surface of a base material being concave or the inner surface of a pipe due to the size of the cutting tool.

Further, the present inventors provided a further advanced method using a laser beam to form grooves on a base material, in which a protective film having a segmented structure can be easily formed at a higher speed, and quality control for the protective film is further improved, so that the film can be applied not only to a two-dimensional shape but also a three-dimensional shape. (Patent Literature 3).

### CITATION LIST

### Patent Literature

Patent Literature 1: JP4117388B
Patent Literature 2: WO2011/030926A1
Patent Literature 3: JP2012-188698A1

### PROBLEMS TO BE SOLVED

The purpose of the present invention is to obtain a protective film having a segmented structure that is stable in terms of strength and that prevents the destruction or damage of a groove structure (a structure formed with a base material and a protective film) due to load deformation stress from outside and inside forces, by means of, in particular, a structure that connects a side surface of a groove to the bottom section of the groove and a structure of the bottom section of the groove.

### MEANS TO SOLVE THE PROBLEMS

The present invention provides the following inventions in order to solve the above problems:
(1) A protective film having a segmented structure, the film being formed by depositing a film on a base material, wherein the protective film is obtained by depositing the protective film, after machining a groove in the base material, forming spaces between the segmented protective film on the base material, and the vertical cross-sectional surface of a part where the groove side surface and the groove bottom surface intersect is connected by a downward convex curve and the vertical cross-sectional surface of the bottom section of the groove is a downward convex curve or a straight line.
(2) The protective film according to the above (1) wherein the inclination angle (α) of the groove side surface to the surface of the base material is 60 degrees or less.
(3) The protective film according to the above (1) or (2) wherein the groove is formed in a flow path or pond shape.
(4) The protective film according to any one of the above (1) to (3) wherein the protective film is selected from diamond-like carbon, diamond, BN, WC, CrN, HfN, VN, TiN, TiCN, Al₂O₃, ZnO and SiO₂ films, and a combination thereof.
(5) The protective film according to any one of the above (1) to (4) wherein the protective film is selected from a metal plated film, an alumite film, a polymeric film, and a combination thereof.
(6) The protective film according to any one of the above (1) to (5) wherein the groove machining is selected from laser processing, cutting work, heat treatment, grinding work, plastic work, electric discharge machining, 3D processing, water jet machining, injection molding process, casting work, etching processing, and a combination thereof.
(7) A protective film having a segmented structure, the film being formed by depositing a film on a base material, wherein the protective film is obtained by depositing the protective film, followed by machining a groove in the protective film, forming spaces between the segmented protective film on the base material, and the vertical cross-sectional surface of a part where the groove side surface and the groove bottom surface intersect is connected by a downward convex curve and the vertical cross-sectional surface of the bottom section of the groove is a downward convex curve or a straight line.
(8) The protective film according to the above (7) wherein the inclination angle (α) of the groove side surface to the surface of the protective film is 60 degrees or less.
(9) The protective film according to the above (7) or (8) wherein the groove is formed in a flow path or pond shape.
(10) The protective film according to any one of the above (7) to (9) wherein the protective film is selected diamond-like carbon, diamond, BN, WC, CrN, HfN, VN, TiN, TiCN, Al₂O₃, ZnO and SiO₂ films, and a combination thereof.
(11) The protective film according to any one of the above (7) to (10) wherein the protective film is selected from a metal plated film, an alumite film, a polymeric film, and a combination thereof.
(12) The protective film according to any one of the above (7) to (11) wherein the groove machining is selected from laser processing, cutting work, heat treatment, grinding work, plastic work, electric discharge machining, 3D processing, water jet machining, injection molding process, casting work, etching processing, and a combination thereof.
(13) A protective film having a segmented structure, the film being formed by depositing a film on a base material, wherein the protective film is obtained by depositing the protective film, followed by machining a groove in the protective film and the base material, forming spaces between the segmented protective film on the base material, and the vertical cross-sectional surface of a part where the groove side surface and the groove bottom surface intersect is connected by a downward convex curve and the vertical cross-sectional surface of the bottom section of the groove is a downward convex curve or a straight line.
(14) The protective film according to the above (13) wherein the inclination angle (α) of the groove side surface to the surface of the protective film is 60 degrees or less.
(15) The protective film according to the above (13) or (14) wherein the groove is formed in a flow path or pond shape.
(16) The protective film according to any one of the above (13) to (15) wherein the protective film is selected from diamond-like carbon, diamond, BN, WC, CrN, HfN, VN, TiN, TiCN, Al₂O₃, ZnO and SiO₂ films, and a combination thereof.
(17) The protective film according to any one of the above (13) to (16) wherein the protective film is selected from a metal plated film, an alumite film, a polymeric film, and a combination thereof.
(18) The protective film according to any one of the above (13) to (17) wherein the groove machining is selected from laser processing, cutting work, heat treatment, grinding work, plastic work, electric discharge machining, 3D processing, water jet machining, injection molding process, casting work, etching processing, and a combination thereof.
(19) A method for producing a protective film having a segmented structure, the film being formed by depositing a film on a base material, wherein the protective film is obtained by depositing the protective film, after machining a groove in the base material, forming spaces between the segmented protective film on the base material, and the vertical cross-sectional surface of a part where the groove side surface and the groove bottom surface intersect is connected by a downward convex curve and the vertical cross-sectional surface of the bottom section of the groove is a downward convex curve or a straight line.
(20) A method for producing a protective film having a segmented structure, the film being formed by depositing a film on a base material, wherein the protective film is obtained by depositing the protective film, followed by machining a groove in the protective film, forming spaces between the segmented protective film on the base material, and the vertical cross-sectional surface of a part where the groove side surface and the groove bottom surface intersect is connected by a downward convex curve and the vertical cross-sectional surface of the bottom section of the groove is a downward convex curve or a straight line.
(21) A method for producing a protective film having a segmented structure, the film being formed by depositing a film on a base material, wherein the protective film is obtained by depositing the protective film, followed by machining a groove in the protective film and the base material, forming spaces between the segmented protective film on the base material, and the vertical cross-sectional surface of a part where the groove side surface and the groove bottom surface intersect is connected by a downward convex curve and the vertical cross-sectional surface of the bottom section of the groove is a downward convex curve or a straight line.
(22) A grooved base material wherein the vertical cross-sectional surface of a part where the groove side surface and the groove bottom surface intersect is connected by a downward convex curve and the vertical cross-sectional surface of the bottom section of the groove is a downward convex curve or a straight line.
(23) The base material according to the above (22) wherein the groove machining is selected from laser processing, cutting work, heat treatment, grinding work, plastic work, electric discharge machining, 3D processing, water jet machining, injection molding process, casting work, etching processing, and a combination thereof.
(24) The base material according to the above (22) or (23) wherein the inclination angle (α) of the groove side surface to the surface of the base material is 60 degrees or less.
(25) The base material according to any one of the above (22) to (24) wherein the groove is formed in a flow path or pond shape.

### ADVANTAGEOUS EFFECTS OF INVENTION

According to the present invention, a protective film having a segmented structure can be obtained, in which the protective film is stable in terms of strength and prevents the destruction or damage of a groove structure (a structure formed with a base material and a protective film) due to load deformation stress from outside and inside forces, by means of, in particular, a structure that connects a side surface of a groove to the bottom section of the groove and a structure of the bottom section of the groove.

### BRIEF DESCRIPTION OF DRAWINGS

FIG. 1 illustrates three embodiments that produce a protective film having a segmented structure, and a groove with the protective film.
FIG. 2 is a longitudinal sectional view of an example of groove machining on a base material using cutting work.
FIG. 3 is a plane view of an example of a protective film in which a variety of grooves are formed on a base material.
FIG. 4 illustrates a plane view and a longitudinal sectional view of an example of a groove formed in a pond-like shape.
FIG. 5 illustrates an example of an apparatus that produces a protective film on a base material.

### DESCRIPTION OF EMBODIMENTS

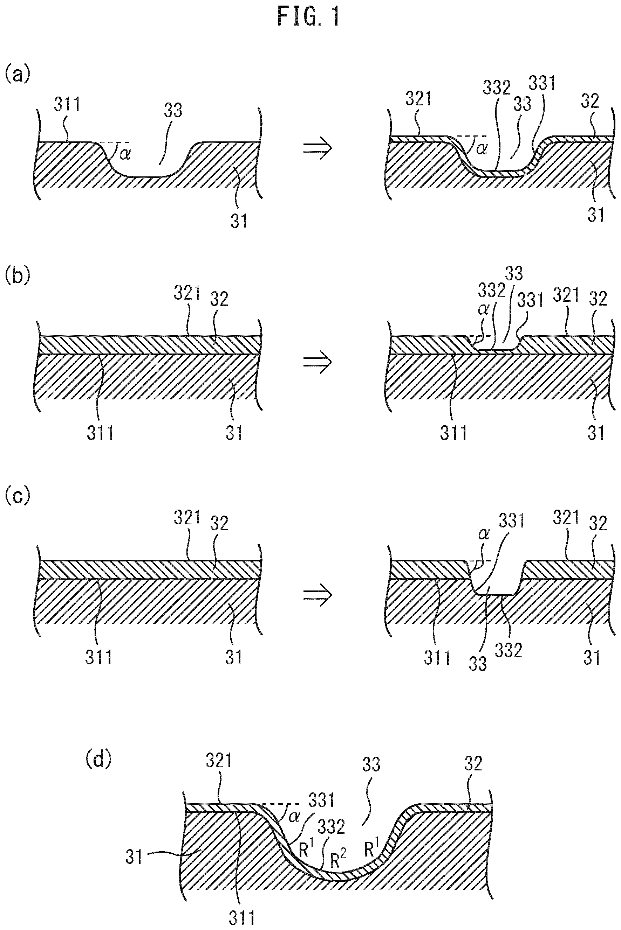

In an embodiment of the present invention, a protective film is that having a segmented structure, and as shown, in FIG.1 (a), the film is formed by depositing a film on a base material, in which the protective film is obtained by depositing the protective film, after machining a groove in the base material, forming spaces between the segmented protective film on the base material. The vertical cross-sectional surface of a part where the groove side surface and the groove bottom surface intersect is connected by a downward convex curve and the vertical cross-sectional surface of the bottom section of the groove is a downward convex curve or a straight line. Thereby, deformation stress which causes the destruction or damage of the groove structure is not concentrated, and easily propagated to the base material.

Namely, the shape of the part where the groove side surface and the groove bottom surface intersect, corresponding to the corner, is connected by a downward convex curve. Further, the shape of the vertical cross-sectional surface of the bottom section of the groove is a downward convex curve (for example, approximating a part of an ellipsoid) or a straight line. The shape of the vertical cross-section of the groove is selected from U-shaped, and so on.

The "downward convex curve" means that the cross-sectional shape, that is formed by the groove side surface, the groove bottom surface and the opposing groove side surface, is downward convex curve, in which the curvature of the groove side surface and the groove bottom surface gradually changes in such a manner that a part where the groove side surface and the groove bottom surface intersect is connected by a curve (R¹), at a position near the groove side surface the curvature is large (i.e., the radius of curvature is small; rapidly curved), and the curvature is small (i.e., the radius of curvature is large; gently curved) at the center of the groove bottom surface (R²). This curve becomes preferably a part of an ellipsoid. However, it is impossible to obtain such a strict ellipsoid, and hence the curve can approximately be a part of an ellipsoid in a controllable range. In FIG.1 (d), R¹ is the intersection of the groove side surface and the groove bottom surface, and R² is the center of the groove bottom surface. According to this constitution, deformation stress which causes the destruction or damage of the groove structure is not concentrated, and easily propagated to the base material.

When the vertical cross-sectional surface of the bottom section of the groove is a straight line, a curve is preferably formed between the groove side surface and the groove bottom surface. For example, a part where the groove side surface and the groove bottom surface intersect is connected by a curve (R¹) and the vertical cross-sectional surface of the bottom section extended from the part is a straight line.

Further, the inclination angle (α) of the groove side surface to the surface of the base material is preferably 60 degrees or less, more preferably 25±20 degrees, so that deformation stress which causes the destruction or damage of the groove structure is not concentrated, and easily propagated to the base material.

In FIG.1 (a), reference numeral 31 is a base material, 311 is the surface of the base material, 32 is a protective film, 321 is the surface of the protective film, 33 is a groove, 331 is an inclined side surface, and 332 is the bottom section of the groove. α is the inclination angle of the groove side surface to the surface of the base material.

The inclination angle of the groove side surface can be measured using a laser microscope, such as VK-9710 of KEYENCE Corporation, by sequentially measuring the distance from the horizontal surface (corresponding to the surface of the base material or protective film) to the groove side surface.

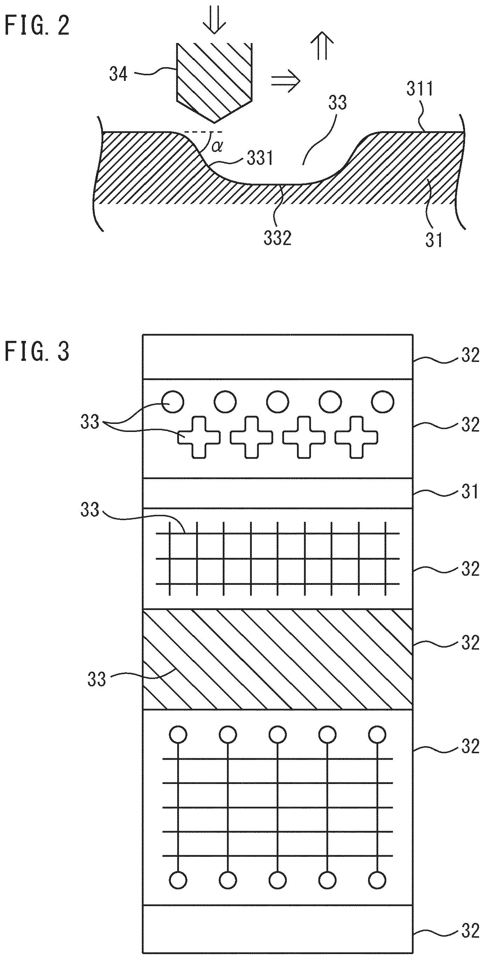

FIG. 2 is a longitudinal sectional view of an example of groove machining of a base material using a cutting work. α is the inclination angle of the groove side surface to the surface of the base material. In FIG. 2, reference numeral 31 is a base material, 311 is the surface of the base material, 33 is a groove, 331 is an inclined side surface of the groove, 332 is the bottom section of the groove, and 34 is a cutting tool. Base material 31 is cut up to a predetermined depth by literally moving cutting tool 34 to intrude to the downward side, thereby the inclined side surface is formed. Further, another opposing inclined side of the groove is formed by literally moving cutting tool 34 to a predetermined position and pulling cutting tool 34 upward while holding its moving direction. Similarly, the groove is formed in the perpendicular direction to FIG.2. The shoulder parts of the two inclined side surface of the groove are preferably machined to a desired, appropriate radius of curvature, as described below. Then, a protective film (not shown in FIG.2) is deposited on base material 31.

The protective film is also deposited on inclined side surface of the groove 331 and bottom section of the groove 332, while the depositing rates thereof is lower than that of the surface of base material 311, and hence the depth of the protective film on the groove surface is smaller than that of the surface of base material 311. Even though the depth of the film on the inclined side surface and the bottom section of the groove may be small, the film is not intended to receive a stress, which may be applied to the inclined surface of the groove as a part of a stress applied to the surface of the protective film, and hence it does not affect overall wear resistance improvement and low friction sliding.

Groove machining is selected from at least one or a combination of laser processing, cutting work, heat treatment, grinding work, plastic work, electric discharge machining, 3D processing, water jet machining, injection molding process, casting work, and etching processing. Further, polishing may be used for adjusting the surface roughness of a groove.

In the groove machining of a base material, a variety of pretreatment may be applied to the base material. Included are, for example, nitriding in which nitrogen is infiltrated to a metal for surface hardening, carburizing in which carbon is added to a metal for surface hardening, thermal refining in which steel is quenched and then tempered for improving toughness, chromizing in which chrome is diffused and infiltrated in a metal for improving corrosion resistance and wear resistance, and phosphate treatment in which a film such as zinc phosphate is formed on the surface of steel for improving corrosion resistance and adhesion.

In laser processing, according to a processed object and using conditions, YAG laser (basic wave, second harmonic wave, third harmonic wave), CO₂ laser, argon laser, Excimer laser (ArF, KrF), fiber laser, femtosecond laser, and picosecond laser, etc., may preferably be used.

When a protective film is a carbon-based material such as DLC and diamond, a temperature of 300°C or high may cause the change of crystal conditions of the material so as to increase in the graphite content, resulting in the decrease in hardness. When groove machining is conducted in an oxidation environment (O₂ gas, air, O₃ gas), CO₂ may generate. Thus, when a laser beam is irradiated in an oxidation environment, a predetermined part is changed to graphite or CO₂ which can easily be removed.

In cutting work, the object to be processed is cut from the surface to the interior, in which a grove pattern can be carved using machine tool, such as a milling tool, machining center, multi-axis machining center, jig borer, NC lathe, and automatic lathe.

In heat treatment, when a protective film is treated, it is possible to use a heat for changing the protective film. Further, red-heated fine metal powder can be pressed to the surface of the protective film so as to change the composition of the protective film that is affected by heat, which is effective, in particular, for a carbon-based protective film such as DLC and diamond film.

Grinding work includes grinding machining, machining center, grooving, and so on, using abrasive grains. A groove can be carved at a predetermined angle by designing the tip of a grinding stone or abrasive tool.

In plastic work, a material, which is harder than an object to be processed, such as a mold, cutter, drawing die, tool, and so on, is pressed to a mating base material so as not to return the pressed shape to the original shape. The work includes a single processing such as press work, nanoimprinting, and knurling, and a continuous processing in which a base material moves.

Electric discharge machining is a metal processing method in which the fusion and working are conducted with an arc discharge between a base material and a mold. A predetermined pattern can be carved by a diemilling or wire-cut method using an electric discharge machine.

In 3D processing, a patterning mask can be deposited using a resin or metal by a 3D printer, in which the height of the pattern can characteristically be varied. Commonly known 3D printers forms a shape by depositing a resin and metal, and basically have a bed moving in the YZ-axis direction and a printer head for discharging a resin, etc., or a synchronizing mechanism of a laser for melting metal powder. 3D processing can be conducted by adding a mechanism for rotating a work (i.e., an object to be processed) to this function. In this method, a carving component, such as an ink which contains a corrosive substance, is printed, and then a part to be corroded is carved when a predetermined time passes, in which a separate part can characteristically be carved. In a mask etching, a carved groove part, which corresponds to a pattern, becomes continuous. In this method, on the other hand, separate grooves (pond-shaped hollows) can be formed. Further, a large area can be processed in a limited time.

Water jet machining is a machining method, in which abrasives are added to water, and the abrasives-added water is sprayed with a high pressure of e.g., 2000 atmospheric pressure, so that an object to be processed is cut or carved.

Injection molding process is a processing method, in which a resin is melted by heating, and the melting resin is injected into a mold and is cooled and solidified to form a molded article having a desired groove.

In casting work, a so-called lost-wax process is preferably used, in which a wax mold is formed, the periphery thereof is covered with casting sand, and a molten metal is poured into the cavity formed by melting the wax and removing the melted wax.

Etching processing is a die sinking through a mask pattern by an etchant. The mask pattern can be combined in various ways, and multiple die sinkings can be performed at the same time by setting the mask pattern at the same time. The depth of curvature can be changed according to the contact time with an etchant. Further, the etching time can be controlled by DC connecting to an external electrode, in which the etchant acts as an electrolyte (electrolytic polishing).

Grooves are formed in a manner such that the grooves have the size and shape according to a distance between the segments. The above laser processing is mainly explained below. The width (size) and depth can be controlled by adjusting the output power, beam diameter and focus of the laser beam.

The lower limit of the width of a groove using a micro-router, which is commonly used as a mechanical tool, and hence finer groove machining is possible by using a laser beam. The upper limit of the groove width can be extended infinitely by shifting a laser beam and repeating groove machining. The depth of the groove can arbitrarily be adjusted in the range of about 1µm or more by repeating. In groove machining, a space between each groove can arbitrarily be adjusted in the range of about 2µm or more, in which a fine segmented structure and a large segmented structure can gradationally be set.

When the base material is groove-machined using a laser beam, a pattern (figure), a film thickness and groove width and groove depth may freely be combined. Further, the groove machining pattern may freely be set and hence the curvature radius of a curve of the groove may arbitrarily be set. Thus, various segment patterns are applied to one base material and hence a protective film, having an optimum segmented structure, depending on its application may be obtained. Marking or naming can also be performed using the protective film with a segmented structure, since the groove machining pattern may freely be set. Furthermore, by changing the location, size and range of the segmented structure, the width and bending manner of a groove can also freely be controlled, and the groove can also easily be used as a flow path or a closed groove (pond) which is available for an oil pit (oil reservoir).

Even when an object to be processed cannot be accessed using a cutting tool which requires a mechanical contact, a laser beam can easily access the object by means of an optical contact. The laser beam can be irradiated using a reflection mirror or an optical fiber, and hence a processing with a higher degree of freedom can be performed. Furthermore, an object to be processed is almost free from restrictions by the shape of the surface.

After machining a groove in a base material using a laser beam, a protective film is deposited on the base material, forming spaces between the segmented protective film. The width of the groove is selected from the range of 0.1 µm to 1 mm, which is the spacing to adjacent segments. The depth of the groove is selected from the range of 1µm to 2 mm. This is because it is currently difficult to uniformly introduce a groove of 1µm or less due to cutting precision using a laser beam, the lower limit is therefore around 1µm.

As described above, the vertical cross-sectional surface of a part where the groove side surface and the groove bottom surface intersect is connected by a downward convex curve and the vertical cross-sectional surface of the bottom section of the groove is a downward convex curve or a straight line. Thereby, deformation stress which causes the destruction or damage of the groove structure is not concentrated, and easily propagated to the base material.

Only a groove depth corresponding to a film thickness, or equivalently, a groove depth of several nanometers to several hundred micrometers can be obtained in the protective film having a segmented structure made by a masking method with a drawing material, while a groove with a depth of around 1mm can easily be made according to this method of groove-machining the base material using a laser beam. A deposited film has a thickness of 1nm to 200µm, and a groove has a sufficient depth of around 1 µm to 2mm, and hence the protective film, deposited after the groove-machining of a base material, is divided by grooves to obtain the protective film having a segmented shape on the uppermost surface of the base material, which receives a contact stress and relates to wear resistance and friction sliding. In a groove section, the thickness of the protective film may relatively be thinner than that of the uppermost surface of the base material. When (groove depth/groove width) is large, a protective film can be divided at the groove side surface or groove bottom surface. Thereby, a protective film having a segmented shape is obtained. So as to divide the film, the groove depth is commonly at least 5 times of the thickness of a desired protective film, preferably at least 20 times, more preferably at least 50 times, still more preferably at least 100 times, and most preferably at least 150 times.

A residue generated in laser processing may be formed as a shape projecting from the surface of a base material in which a so-called burr may be formed in a peripheral part of a groove section. This burr is preferably removed as needed. Deburring can be performed using a physical method without damaging a base material.

A laser beam can also be applied to remove a burr. The burr is melted by heating and deformed by irradiating a defocused or output-adjusted laser beam to a part to be groove-machined, so that the shoulder part of the groove (i.e., the side where the surface of a base material and the groove side surface intersect, and the vicinity thereof) can be smoothed. For example, the shoulder part of the groove can be curved with a radius of curvature larger than the thickness of a protective film. The focus (defocus), output, offset amount and reciprocation of a laser beam can adequately be adjusted until the shoulder part of the groove has a desired shape.

An appropriate tool or processing is available for removing a burr according to the material of a base material, and a desired size and shape of a groove. For example, polishing by sandpaper, buffing, fluid polishing, magnetic polishing, sand blasting, blasting by solid carbon dioxide powder polishing, grinding by a rotary grindstone, etching by isotropic dry etching, and electro-polishing by an electrolytic solution, etc., can be used. Any combination of these processing may be used. Deburring with a laser beam, followed by deburring without the laser beam, is advantageous from the view point of quality control, since the shoulder part of the groove can be formed in high accuracy.

A base material used in accordance with the present invention is not particularly limited but includes, for example, metals such as aluminum alloys, magnesium alloys, cupper alloys, titanium alloys, heat-resistant alloys, stainless alloys, tungsten alloys, and steel; polymeric materials such as plastics; rubbers; ceramics; carbon-based materials such as CFRP and composite materials thereof; and may appropriately be selected depending on a purpose.

The surface of the base material on which the protective film is deposited may have a three-dimensional shape. The three-dimensional shape is a plane, particularly a curved plane, made by plastic processing such as press processing, cutting work, and the surface of a stereoscopic object obtained by injection molding, die casting, MIM (Metal injection Mold), sintering, firing or the like.

A protective film is deposited after the groove-machining of a base material, in which the protective film is deposited on the base material including the groove-machined part, and is divided by grooves to obtain the protective film having a segmented shape, since the groove depth is sufficiently larger than the thickness of the protective film so that a recess is formed in the groove.

The segment has a shape that is not particularly limited but may appropriately be selected from a polygonal, such a triangle and quadrangle; a circle and the like. For example, a soccer ball shape, obtained by combining pentagons and hexagons, is also applicable for the segment. Further, a spherical surface-shaped segment is also applicable. The segment may be divided by the grooves different in the width or depth from each other. The segments have sizes that are usually selected from one side or an outside diameter of 1 µm to 3 mm. In addition, the segments usually have a film thicknesses of 1 nm to 200 µm.

The planar shape of the groove can be a grid-like, stripe-like, pond-like pattern, or a combination thereof. The grooves can be a flow path or closed pond. The pond may be an oil reservoir. Further, the grooves may be a lubricant layer by introducing a fluid or solid lubricant to the groove part.

FIG.3 is a plane view of an example of a protective film in which a variety of grooves are formed on a base material. In FIG. 3, 31 is a base material, 32 is a protective film, and 33 is a variety of grooves (pond-like, lattice-like and stripe-like patterns) formed on protective film 32.

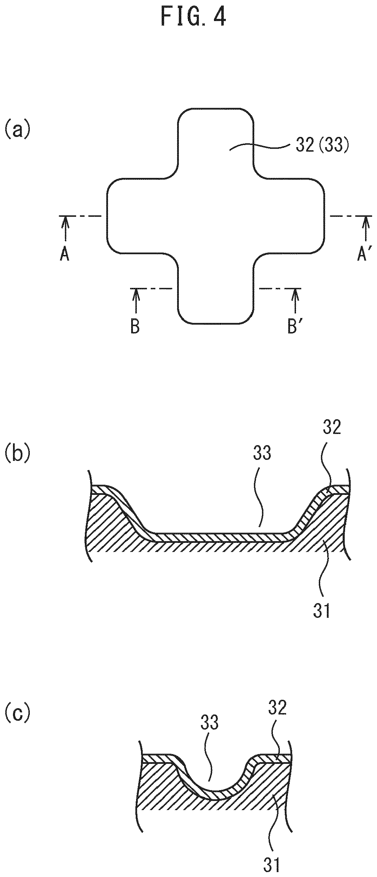

FIG. 4 are a plane view (a) and longitudinal sectional views (b) and (c) of an example of a groove formed in a pond-like shape, in which (b) is a A-A' line section view and (c) is a B-B' line section view.

In one embodiment of the present invention, the protective film is selected from diamond-like carbon, diamond, BN, WC, CrN, HfN, VN, TiN, TiCN, Al₂O₃, ZnO and SiO₂ films, and a combination thereof.

A vapor phase deposition method is preferably applied as a protective film deposition method, of which examples include plasma CVD with a direct-current power source, an alternating-current power source, a high frequency power source, a pulsed power source or the like as a power source, or a sputtering method such as magnetron sputtering or ion beam sputtering. PVD (physical vapor phase deposition method) can also be used so as to obtain a similar protective film.

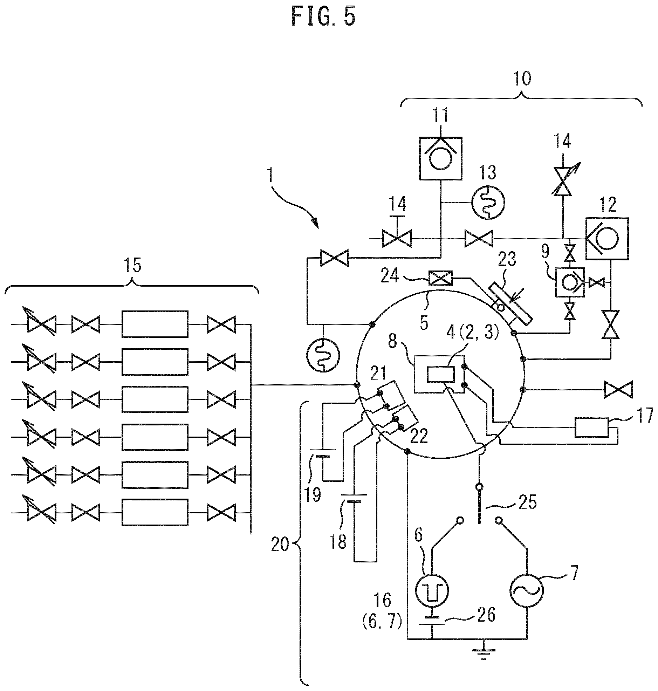

The fundamental constitution of the film formation apparatus is illustrated in FIG. 5. Illustrated is the scheme of the apparatus equipped with chamber 5, exhaust system 10 (rotary pump 11, turbo molecular pump 12, vacuum gauge 13, exhaust valve 14, etc.,), gas introduction system 15 (a valve for introducing gases such as Ar, C₂H₂, Si (CH₃)₄), H₂, O₂, N₂, CH₄ and CF₄) and power source system 20 (main power source 16, base material heating power source 17, fine particles trapping filter power source 18, surplus electrons collecting power source 19 and the like).

A base material which is grooved-machined is connected to a cathode electrode in a chamber in this apparatus. Air is exhausted from the inside of the chamber by an evacuation mechanism after the placing of the base material, plasma gas sources, Ar, Si (CH₃)₄, C₂H₂ and the like are then supplied, a pulsed voltage is applied by a pulsed power source, and the plasma gas sources are made to be plasma. The gas made to be the plasma is deposited on the base material. The groove depth is set sufficiently larger than the film thickness and hence the film is divided in the groove section. The deposited film on the groove side surface or the groove bottom surface, the film being relatively thin compared with that of a uppermost surface of the base material, may be a reduced dynamic function as a protective film, but they show a function to improve the chemical stability.

The film formation rate in the groove part can be adjusted by appropriately selecting the atmosphere of groove-machining by a laser beam. Specifically, an object to be processed can easily be oxidized in an oxidizing atmosphere such as oxygen, ozone, etc. An oxide is usually has a low electric conductivity and hence a current is suppressed to flow to the groove part, which is oxidized during film formation, so that the film formation in the groove is suppressed. Thereby, a protective film is easily formed in the place, where no grooves are exist, to obtain the protective film having a segmented shape.

An electric current is not likely to flow in a base material having a low electrical conductivity, thereby suppressing the temperature rising of the base material. This is advantageous for extending a range of choice of a base material.

The atmosphere of groove-machining by a laser beam may be an inert gas such as argon, nitrogen gas, etc., so as to suppress the oxidation of the groove surface.

The deposited protective film may preferably be imparted with wear resistance and may contain any or a combination of, e.g., diamond-like carbon, diamond, BN, WC, CrN, HfN, VN, TiN, TiCN, Al₂O₃, ZnO and SiO₂ films. The thicknesses of these films are selected usually from 1 nm to 200 µm.

In another embodiment of the present invention, the protective film is selected from a metal plated film, an alumite film, a polymeric film, and a combination thereof. These films can be formed by a conventional method. The metal plated film is preferably formed by a wet nickel or chrome plating, the alumite film is formed by an anode oxidation, and the polymeric film is preferably formed by a fluorine resin coating. The thickness of these protective films is usually selected from 50nm to 500µm. The protective films may be divided by a groove or be continuous.

In another embodiment of the present invention, the protective film has a segmented structure and is formed by depositing a film on a base material. As shown in FIG.1 (b), protective film 32 is deposited on base material 31 (base material surface 311 is usually parallel with protective surface 321), followed by machining a groove in protective film 32 to form spaces between the segmented protective film. The vertical cross-sectional surface of a part where the groove side surface and the groove bottom surface intersect is connected by a downward convex curve and the vertical cross-sectional surface of the bottom section of the groove is a downward convex curve or a straight line. Thereby, deformation stress which causes the destruction or damage of the groove structure is not concentrated, and easily propagated to the base material. Further, the inclination angle (α) of the groove side surface to the surface of the protective film is preferably 60 degrees or less, more preferably 25±20 degrees, so that deformation stress which causes the destruction or damage of the groove structure is not concentrated, and easily propagated to the base material. When the surface of the protective film is curved, the inclination angle is an angle from the tangent of the abutting position.

In a further embodiment of the present invention, as shown in FIG.1 (c), the protective film has a segmented structure and is formed by depositing a film on a base material. Protective film 32 is deposited on base material 31 (base material surface 311 is usually parallel with protective surface 321), followed by machining a groove in protective film 32 and base material 31 to form spaces between the segmented protective film. The vertical cross-sectional surface of a part where the groove side surface and the groove bottom surface intersect is connected by a downward convex curve and the vertical cross-sectional surface of the bottom section of the groove is a downward convex curve or a straight line. Thereby, deformation stress which causes the destruction or damage of the groove structure is not concentrated, and easily propagated to the base material. Further, the inclination angle (α) of the groove side surface to the surface of the protective film is preferably 60 degrees or less, more preferably 25±20 degrees, so that deformation stress which causes the destruction or damage of the groove structure is not concentrated, and easily propagated to the base material. When the surface of the protective film is curved, the inclination angle is an angle from the tangent of the abutting position.

In another embodiment of the present invention, the grooved base material is provided, in which the vertical cross-sectional surface of a part where the groove side surface and the groove bottom surface intersect is connected by a downward convex curve and the vertical cross-sectional surface of the bottom section of the groove is a downward convex curve or a straight line. Thereby, deformation stress which causes the destruction or damage of the groove structure is not concentrated, and easily propagated to the base material. Further, the inclination angle (α) of the groove side surface to the surface of the base material is preferably 60 degrees or less, more preferably 25±20 degrees.

Groove machining is selected from laser processing, cutting work, heat treatment, grinding work, plastic work, electric discharge machining, 3D processing, water jet machining, injection molding process, casting work, etching processing, and a combination thereof. The planar shape of the groove can preferably be a grid-like, stripe-like, pond-like pattern, or a combination thereof. Preferably, the vertical cross-sectional surface of the bottom section of the groove is a downward convex curve or a straight line. The width and depth of the groove is as described above.

The base material of the present invention is preferable for forming the above-described protective film having a segmented structure thereon, in which the protective film is stable in terms of strength and prevents the destruction or damage due to load deformation stress from outside and inside forces. Further, the base material of the present invention can be adjusted to change the surface strength according to a position in the surface by combining different grooves.

### INDUSTRIAL APPLICABILITY

According to the present invention, it is possible to provide a protective film having a segmented structure that has stability to stress from outside and inside forces.

### REFERENCE SIGNS LIST

31 Base material
311 Surface of base material
32 Protective film
321 Surface of protective film
33 Groove
331 Inclined side of groove
332 Bottom portion of groove
34 Cutting tool
5 Chamber
10 Exhaust system
15 Gas introduction system
20 Power source system

## Claims

1. A protective film having a segmented structure, the film being formed by depositing a film on a base material, wherein the protective film is obtained by depositing the protective film, after machining a groove in the base material, forming spaces between the segmented protective film on the base material, and the vertical cross-sectional surface of a part where the groove side surface and the groove bottom surface intersect is connected by a downward convex curve and the vertical cross-sectional surface of the bottom section of the groove is a downward convex curve or a straight line.

2. The protective film according to claim 1 wherein the inclination angle (α) of the groove side surface to the surface of the base material is 60 degrees or less.

3. The protective film according to claim 1 or 2 wherein the groove is formed in a flow path or pond shape.

4. The protective film according to any one of claims 1 to 3 wherein the protective film is selected from diamond-like carbon, diamond, BN, WC, CrN, HfN, VN, TiN, TiCN, Al₂O₃, ZnO and SiO₂ films, and a combination thereof.

5. The protective film according to any one of claims 1 to 4 wherein the protective film is selected from a metal plated film, an alumite film, a polymeric film, and a combination thereof.

6. The protective film according to any one of claims 1 to 5 wherein the groove machining is selected from laser processing, cutting work, heat treatment, grinding work, plastic work, electric discharge machining, 3D processing, water jet machining, injection molding process, casting work, etching processing, and a combination thereof.

7. A protective film having a segmented structure, the film being formed by depositing a film on a base material, wherein the protective film is obtained by depositing the protective film, followed by machining a groove in the protective film, forming spaces between the segmented protective film on the base material, and the vertical cross-sectional surface of a part where the groove side surface and the groove bottom surface intersect is connected by a downward convex curve and the vertical cross-sectional surface of the bottom section of the groove is a downward convex curve or a straight line.

8. The protective film according to claim 7 wherein the inclination angle (α) of the groove side surface to the surface of the protective film is 60 degrees or less.

9. The protective film according to claim 7 or 8 wherein the groove is formed in a flow path or pond shape.

10. The protective film according to any one of claims 7 to 9 wherein the protective film is selected from diamond-like carbon, diamond, BN, WC, CrN, HfN, VN, TiN, TiCN, Al₂O₃, ZnO and SiO₂ films, and a combination thereof.

11. The protective film according to any one of claims 7 to 10 wherein the protective film is selected from a metal plated film, an alumite film, a polymeric film, and a combination thereof.

12. The protective film according to any one of claims 7 to 11 wherein the groove machining is selected from laser processing, cutting work, heat treatment, grinding work, plastic work, electric discharge machining, 3D processing, water jet machining, injection molding process, casting work, etching processing, and a combination thereof.

13. A protective film having a segmented structure, the film being formed by depositing a film on a base material, wherein the protective film is obtained by depositing the protective film, followed by machining a groove in the protective film and the base material, forming spaces between the segmented protective film on the base material, and the vertical cross-sectional surface of a part where the groove side surface and the groove bottom surface intersect is connected by a downward convex curve and the vertical cross-sectional surface of the bottom section of the groove is a downward convex curve or a straight line.

14. The protective film according to claim 13 wherein the inclination angle (α) of the groove side surface to the surface of the protective film is 60 degrees or less.

15. The protective film according to claim 13 or 14 wherein the groove is formed in a flow path or pond shape.

16. The protective film according to any one of claims 13 to 15 wherein the protective film is selected from diamond-like carbon, diamond, BN, WC, CrN, HfN, VN, TiN, TiCN, Al₂O₃, ZnO and SiO₂ films, and a combination thereof.

17. The protective film according to any one of claims 13 to 16 wherein the protective film is selected from a metal plated film, an alumite film, a polymeric film, and a combination thereof.

18. The protective film according to any one of claims 13 to 17 wherein the groove machining is selected from laser processing, cutting work, heat treatment, grinding work, plastic work, electric discharge machining, 3D processing, water jet machining, injection molding process, casting work, etching processing, and a combination thereof.

19. A method for producing a protective film having a segmented structure, the film being formed by depositing a film on a base material, wherein the protective film is obtained by depositing the protective film, after machining a groove in the base material, forming spaces between the segmented protective film on the base material, and the vertical cross-sectional surface of a part where the groove side surface and the groove bottom surface intersect is connected by a downward convex curve and the vertical cross-sectional surface of the bottom section of the groove is a downward convex curve or a straight line.

20. A method for producing a protective film having a segmented structure, the film being formed by depositing a film on a base material, wherein the protective film is obtained by depositing the protective film, followed by machining a groove in the protective film, forming spaces between the segmented protective film on the base material, and the vertical cross-sectional surface of a part where the groove side surface and the groove bottom surface intersect is connected by a downward convex curve and the vertical cross-sectional surface of the bottom section of the groove is a downward convex curve or a straight line.

21. A method for producing a protective film having a segmented structure, the film being formed by depositing a film on a base material, wherein the protective film is obtained by depositing the protective film, followed by machining a groove in the protective film and the base material, forming spaces between the segmented protective film on the base material, and the vertical cross-sectional surface of a part where the groove side surface and the groove bottom surface intersect is connected by a downward convex curve and the vertical cross-sectional surface of the bottom section of the groove is a downward convex curve or a straight line.

22. A grooved base material wherein the vertical cross-sectional surface of a part where the groove side surface and the groove bottom surface intersect is connected by a downward convex curve and the vertical cross-sectional surface of the bottom section of the groove is a downward convex curve or a straight line.

23. The base material according to claim 22 wherein the groove machining is selected from laser processing, cutting work, heat treatment, grinding work, plastic work, electric discharge machining, 3D processing, water jet machining, injection molding process, casting work, etching processing, and a combination thereof.

24. The base material according to claim 22 or 23 wherein the inclination angle (α) of the groove side surface to the surface of the base material is 60 degrees or less.

25. The base material according to any one of claims 22 to 24 wherein the groove is formed in a flow path or pond shape.
